(19) Europäisches Patentamt
European Patent Office
Office européen des brevets

(11) **EP 3 591 420 B1**

(12) **EUROPEAN PATENT SPECIFICATION**

(45) Date of publication and mention of the grant of the patent:
**31.01.2024 Bulletin 2024/05**

(21) Application number: **18181152.2**

(22) Date of filing: **02.07.2018**

(51) International Patent Classification (IPC):
**G01R 33/44** *(2006.01)*   **G01R 33/38** *(2006.01)*
**G01R 33/561** *(2006.01)*

(52) Cooperative Patent Classification (CPC):
**G01R 33/38; G01R 33/445;** G01R 33/5611

(54) **METHOD AND APPARATUS FOR MRT IMAGING WITH MAGNETIC FIELD MODULATION**

VERFAHREN UND VORRICHTUNG ZUR MRT-BILDGEBUNG MIT MAGNETFELDMODULATION

PROCÉDÉ ET APPAREIL D'IMAGERIE PAR RÉSONANCE MAGNÉTIQUE À MODULATION DE CHAMP MAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**08.01.2020 Bulletin 2020/02**

(73) Proprietors:
• **Max-Planck-Gesellschaft zur Förderung der Wissenschaften e.V.**
  **80539 München (DE)**
• **Eberhard Karls Universität Tübingen**
  **Medizinische Fakultät**
  **72074 Tübingen (DE)**

(72) Inventors:
• **SCHEFFLER, Klaus**
  **72076 Tübingen (DE)**
• **LOKTYUSHIN, Alexander**
  **72076 Tübingen (DE)**
• **BAUSE, Jonas**
  **72076 Tübingen (DE)**

• **ESCHELBACH, Martin**
  **72076 Tübingen (DE)**
• **AGHAEIFAR, Ali**
  **72076 Tübingen (DE)**

(74) Representative: **v. Bezold & Partner Patentanwälte - PartG mbB**
  **Ridlerstraße 57**
  **80339 München (DE)**

(56) References cited:
• **JUERGEN HENNIG ET AL: "Parallel imaging in non-bijective, curvilinear magnetic field gradients: a concept study", MAGNETIC RESONANCE MATERIALS IN PHYSICS, BIOLOGY AND MEDICINE, CHAPMAN AND HALL, LONDON, GB, vol. 21, no. 1-2, 26 February 2008 (2008-02-26), pages 5-14, XP019596833, ISSN: 1352-8661**
• **CHRISTOPH JUCHEM ET AL: "Multi-slice MRI with the dynamic multi-coil technique", NMR IN BIOMEDICINE., vol. 28, no. 11, 30 September 2015 (2015-09-30), pages 1526-1534, XP055532105, GB ISSN: 0952-3480, DOI: 10.1002/nbm.3414**

## Description

Field of the invention

The invention relates to a method and to an apparatus for magnetic resonance tomography (MRT) imaging an object under investigation, e. g. a biological organism, like a patient or a test person, or a part thereof. Applications of the invention are available e. g. in the fields of medical imaging or material investigations.

Technical background

In the present specification, reference is made to the following prior art illustrating technical background of the invention and related techniques:

[1] P. C. Lauterbur in "Nature" 242, 190-191 (1973);
[2] P. Mansfield et al. in "Journal of Physics C, Solid State Physics" 1973; 6, L422-L426;
[3] S. Ljunggren in "J. Magn. Reson." 1983; 54:338-343;
[4] D. B. Twieg in "Med. Phys." 1983; 10:610-621;
[5] W. A. Edelstein et al. in "Phys. Med. Biol." 25,751-756;
[6] K. P. Pruessmann et al. in "Magn. Reson. Med." 1999; 42:952-962;
[7] M. A. Griswold et al. in "Magn. Reson. Med." 2002;47:1202-1210;
[8] J. Hennig et al. in "Magn. Reson. Mater. Phy." 2008; 21:5-14;
[9] US 7 411 395;
[10] US 6 255 821; and
[11] US 2011/0080169 A1.

MRT imaging is a generally known imaging method for detecting spatially resolved MR signals from a spatially extended sample (object under investigation). If the sample is placed within a homogeneous field, a radiofrequency receive coil detects the sum of all signals originating from within the sample. No spatially resolved information is available. The principle of spatially resolved imaging is commonly based on the application of additional linear magnetic field gradients applied independently along the x, y and z axes ([1], [2]). With these gradients the local Larmor frequency of the magnetization becomes linearly dependent on its spatial position. Signals originating from different positions can be identified via their local frequency. Commonly a Fourier transformation is used to transform these frequencies into the spatial domain, i.e. an image in one, two or three dimensions is generated.

Using these linear gradients the spatial composition of the object is acquired in frequency space, or k-space, which is the Fourier transformation of the object space ([3], [4]). Commonly the k-space is acquired in several consecutive steps. The most often used method is the spin warp technique in which k-space is scanned line-by-line using phase encoding gradients in one or two dimensions together with a readout gradient ([5]). However, this line-by-line scanning is a time-consuming process. Depending on the repetition time (TR) between consecutive line scans, which is in the order of 5 ms to 10 s, and the required resolution and further parameters, acquisition of a 2D or 3D image requires about 100 ms to several minutes.

Imaging speed in MRT imaging is of paramount importance, especially in clinical applications, for example to capture the beating heart or to measure blood flow dynamics. Therefore, several methods have been proposed to speed up the MR imaging process. The most successful and important method is Parallel Imaging that has revolutionized medical MR imaging and which is nowadays implemented in any commercial MR scanner. Parallel Imaging is based on the concept of using instead of a single RF receive coil (that collects the sum of all magnetization within this coil) a set of several small RF receive coils. These small RF coils detect only a small portion of the object. Therefore, the local sensitivity profile of these small coils intrinsically provide spatial information of the origin of the magnetization. In Parallel Imaging this local coil sensitivity information is used to speed up the imaging process by a factor 2 to 20, by combining the spatial information produced by linear gradients with the spatial information from local receive coils ([6], [7]).

Switching of strong linear gradients may cause problems in particular in medical MRT imaging as the sample can be influenced by the altering magnetic fields. For avoiding this limitation, a parallel imaging technique has been suggested in [8] to [11] (so called PatLoc-system), which uses localized gradients allowing spatial encoding of MR signals by non-unidirectional, non-bijective spatial encoding magnetic fields (NBSEM fields). The localized spatial encoding is created with an arrangement of gradient coils which generate a static or quasi-static and distinct magnetic field pattern. The magnetic field pattern can be temporarily changed, but on a time scale of switching imaging gradients only. Despite of the advantages of the PatLoc-system in medical imaging, it has some limitations, e. g. in terms of the requirement of applying NBSEM fields, which need a complex field shaping.

Objective of the invention

It is an objective of the invention to provide an improved method of MRT imaging an object under investigation, being capable of avoiding limitations and disadvantages of conventional techniques. In particular, the method is to be capable of MRT imaging with an accelerated collection of MR signals. It is a further objective of the invention to provide an improved magnetic resonance imaging (MRI) device, being capable of avoiding limitations and disadvantages of conventional techniques. In particular, the MRI device is to be capable of accelerated MRT imaging. Furthermore, the MRT imaging method and the MRI device are to be capable of creating the MR signals with an improved quality (e. g. increased signal to noise ratio, SNR) and/or with a reduced complexity of creating local gradient fields.

Summary of the invention

These objectives are solved by a method and/or a device comprising the features of the independent claims. Advantageous embodiments and applications of the invention are defined in the dependent claims.

According to a first general aspect of the invention, the above objective is solved by a method of MRT imaging an object under investigation, wherein the object is positioned in a static magnetic field and subjected to at least one radiofrequency pulse, preferably a radiofrequency pulse sequence, and simultaneously to magnetic field gradients. Spatially encoded MR signals are created in response to the excitation of the object with at least one radiofrequency pulse by the application of the magnetic field gradients (primary spatial encoding of the magnetic resonance signals). The MR signals (MR echoes) are collected, wherein the collecting step includes a phase encoding step and a readout period, and an object image is reconstructed from the MR signals, wherein spatial information obtained by the spatial encoding of the magnetic resonance signals is utilized.

According to the invention, a locally specific frequency modulation of the MR signals (resonance frequency modulation) is created by applying at least one spatially restricted, time-varying magnetic modulation field only during the readout period of the step of collecting the MR signals. The at least one time-varying magnetic modulation field has a component parallel to the static magnetic field. A spatial modulation of the main magnetic field (B0 field) is provided by the magnetic modulation field during MR echo collection, i. e. the spatial modulation occurs during readout of the k-space. The locally specific frequency modulation of the MR signals is introduced by the magnetic modulation field influencing the Larmor frequencies of the excited nuclei. The at least one time-varying magnetic modulation field is spatially restricted to a part of the object. Accordingly, each time-varying magnetic modulation field penetrates a limited section of the object, which is smaller than the whole field of view of the MRT imaging process, while the remaining object is not influenced by the modulation field. The remaining object is subjected to at least one further modulation field applying another specific frequency modulation to at least one further section of the object, or it may be free of a modulation field, thus resulting in an additional spatial encoding of the MR signals. Advantageously, there is no need for sharp delimitations between the sections subjected to different modulation fields. Contrary to gradient switching as disclosed in [8], the magnetic modulation field is applied and the additional spatial encoding of the MR signals is provided during MR echo collection, and it varies on a time scale below the duration of MR echo collection.

Furthermore, according to the invention, the step of reconstructing the object image further includes obtaining additional spatial image information from the spatially encoded magnetic resonance signals, and more specifically, from the locally specific frequency modulation of the spatially encoded

MR signals. When the locally specific frequency modulation is a periodic oscillation, demodulation of the MR signals at the frequencies of the frequency modulation provides an assignment of partial MR images to the related restricted sections of the object under investigation. The partial images are obtained by frequency filtering of MR signals in Fourier space, where each MR signal is specifically frequency-shifted relative to the unmodulated signal by the frequency of modulation. Subsequently, the MR image to be obtained is provided by a superposition of the partial images. Alternatively, the demodulation can be obtained by numerical regression procedures. These can be applied with periodic modulation or preferably if the locally specific frequency modulation has a non-periodic waveform. In both cases, the partial images are obtained simultaneously, so that the imaging process is accelerated.

According to a second general aspect of the invention, the above objective is solved by an MRI device, which includes a magnetic resonance scanner being configured for accommodating an object to be imaged, creating a static magnetic field, at least one radiofrequency pulse and magnetic field gradients, and collecting magnetic resonance signals. Furthermore, the MRI device includes a control device, implemented e. g. by a computer circuit, being configured for controlling the magnetic resonance scanner, and a reconstruction device, implemented e. g. by the same or a further computer circuit, being configured for reconstructing an object image based on the magnetic resonance signals.

According to the invention, the magnetic resonance scanner is further configured for superimposing the static magnetic field with at least one spatially restricted, time-varying magnetic modulation field, which has a component parallel to the static magnetic field. Accordingly, the magnetic resonance scanner is adapted for subjecting the magnetic resonance signals to a locally specific frequency modulation. The magnetic resonance scanner includes a magnetic field modulation source device for creating the magnetic modulation field only during collecting the magnetic resonance signals. Furthermore, according to the invention, the control device is configured for setting the at least one spatially restricted, time-varying magnetic modulation field. Accordingly, the control device is adapted for driving the magnetic resonance scanner, in particular the magnetic field modulation source device, such that the spatially restricted, time-varying magnetic modulation field is superimposed to the static magnetic field during an operation phase of the MR scanner for collecting the MR signals. Furthermore, according to the invention, the reconstruction device is configured for reconstructing the object image by utilizing the locally specific frequency modulation for obtaining additional spatial image information from the spatially encoded magnetic resonance

A main advantage of the invention results from the spatial image information provided by the locally specific frequency modulation of the spatially encoded MR signals additionally to the primary spatial information from the magnetic field gradients. Accordingly, a new parallel imaging technique is introduced which allows an acceleration of the MR imaging and/or an improved MR signal and reconstruction quality.

The invention is based on the local variation of the magnetic field using e. g. local magnetic field coils. This approach is conceptually different to the conventional parallel imaging method, where local RF receive coils are used, that have a spatially confined B1 (radio-frequency magnetic field) distribution. On the contrary, with the invention, the magnetic field modulation source device, including e. g. local magnetic field coils, is used, that has a spatially confined or spatially varying B0 (main magnetic field) distribution.

According to the invention, the at least one spatially restricted, time-varying magnetic modulation field has a modulation frequency being selected such that a temporal frequency modulation of the local Larmor frequencies of the magnetization is obtained. Accordingly, in each restricted spatial section of the object, MR signals are locally collected which are shifted in frequency space relative to the radiofrequency range of the unmodulated MR signals by the local modulation frequency. MR signals collected in different spatial sections with different modulation frequencies provide images with equal amplitudes but different phases. Accordingly, one or several sets of virtual images from the object are produced by induction of locally confined phase differences within this set of virtual images. These virtual images are produced by the local frequency modulated magnetic fields. In the step of reconstruction these local phase variations are used as additional local information within the reconstruction process.

Particularly preferred, the at least one spatially restricted, time-varying magnetic modulation field includes at least one spectral component having a modulation frequency of at least 100 Hz and/or at most 10 MHz. Advantageously, this frequency range facilitates the demodulation of the spatial image information from the MR signals.

Another particular advantage of the invention results from the broad range of available waveforms of the time-varying magnetic modulation fields, which may have any arbitrary waveform, including waveforms having one single frequency and/or multiple frequency components and/or even noise components, in particular within the above preferred frequency range. If the at least one spatially restricted, time-varying magnetic modulation field has a periodically oscillating, in particular sinusoidal or triangular or rectangular, modulation shape, advantages for processing the above virtual images can be obtained.

Advantageously, various types of magnetic field modulation source devices are available which are configured for creating the at least one spatially restricted, time-varying magnetic modulation field. According to a first variant, the magnetic field modulation source device can include at least one local magnetic field coil, preferably an arrangement of local magnetic field coils (coil elements), being arranged adjacent to the object. The local magnetic field coils can be arranged on a reference surface surrounding the object, e. g. on a cylinder surface. Advantageously, such magnetic field coils are known per se. They are available e. g. for creating local magnetic field gradients, as described in [8]. By an appropriate configuration of the control device, local magnetic field coils can be excited such that the inventive time-varying magnetic modulation field is created. Generally, the local magnetic field coil is not provided by a gradient coil creating the regular spatially encoding magnetic field gradients in the MR scanner.

According to a second variant, the magnetic field modulation source device additionally or alternatively can include a shimming device comprising dynamic spherical harmonic shim coils being arranged for shimming a magnetic field distribution in the object according to the magnetic modulation field to be obtained. Contrary to conventional shim coils, the driving signal spherical harmonic shim coils employed according to the invention are driven during MR signal acquisition. As a further advantage, the number, shape and/or spatial arrangement of the local magnetic field coils and/or shim coils can be selected in dependency on the requirements of the MR imaging task. The arrangement of local magnetic field coils and/or shim coils can be exchangeable, so that a given MR scanner can be adapted to the requirements of the MR imaging task. For example, if the degree of parallel imaging is to be increased, the number of coils is increased. The shape and/or the spatial arrangement of the coils can be adapted to the shape of the object under investigation.

According to a further preferred embodiment of the invention, the static magnetic field is superimposed during the readout period with at least two, particularly preferred at least eight to 30 and/or at most 150 spatially restricted, time-varying magnetic modulation fields being localized in different spatial sections of the object. Advantageously, this provides both of an acceleration of the MR imaging process and an improvement of the image quality. The waveforms and/or frequencies (in particular the amplitudes, frequencies, phases and/or modulation shapes) of the time-varying magnetic modulation fields can be changed during MR signal acquisition for each phase encoding step included in the step of acquiring the magnetic resonance signals, in particular at each line in k-space. Additionally or alternatively, the waveform and/or frequencies of the magnetic modulation fields can be different in each spatial section of the object. Furthermore, all time-varying magnetic modulation fields can be controlled independently of each other. Furthermore, amplitude modulated sinusoidal oscillations of the magnetic modulation fields can be provided, wherein the amplitude modulation introduces an additional degree of freedom for spatially resolved image reconstruction. According to a yet further variant, amplitudes and phases of the magnetic modulation fields can be optimized for non-cartesian sampling patterns. These embodiments of the invention can provide advantages for the MR image reconstruction, in particular in spin warp imaging.

The number and/or spatial extension of spatial sections of the object being subjected to different spatially restricted, time-varying magnetic modulation fields can be predetermined operation parameters of the MRI device. These operation parameters can be preset on the basis e. g. of reference or calibration measurements and/or numerical simulations of the magnetic field distribution within the object. Alternatively, according to an advantageous alternative embodiment, the number and/or extension of said spatial sections of the object can be selected in dependency on operation instructions provided by an operator and/or a preliminary object imaging process. For example, a larger number of smaller spatial sections can be selected covering a portion of the object with special features of interest, e.g. altered tissue, compared with the number and/or extension of the spatial sections in the remaining object. Advantageously, this can improve the quality of the reconstructed MR images.

Furthermore, the operator or the control device can select a degree of acceleration to be obtained e. g. by collecting the MR signals of each $n^{th}$ line, e. g. each $2^{nd}$ or $4^{th}$ line, in k-space only. Simultaneously, the number and extension of the spatial sections of the object are selected by the operator or the control device, so that the information lost introduced by the omission of lines in k-space is compensated by the additional spatial information introduced by the local magnetic field modulation. Collecting the MR signals of each $n^{th}$ line represents an example only. Generally, the imaging process can be accelerated by a non-integer factor, and no or nearly all k-space lines could be omitted.

The spatial extension of said spatial sections of the object can be set by the strength of the modulating magnetic field. In particular, individual coil current patterns can be optimized with respect to optimal acceleration performance of MR imaging.

Advantageously, the inventive locally specific frequency modulation of the MR signals can be combined with conventional parallel imaging techniques. Thus, according to a further preferred embodiment of the invention, the step of acquiring the magnetic resonance signals includes parallel sensing the magnetic resonance signals with a plurality of RF coils with spatially restricted sensitivities.

Preferably, the image reconstruction can be obtained by a numerical optimization procedure matching the MR image to be obtained to the MR signals collected. In particular, the step of reconstructing the object image $m$ includes solving a linear equation system $s = E\,m$ by a regularized optimization, wherein $s$ includes the measured MR signals and $E$ is an encoding matrix being determined by the spatial encoding of the magnetic resonance signals and depending on the time-varying modulation components of the modulating magnetic field(s). Details of the encoding matrix are described below.

Brief description of the drawings

Further advantages and details of the invention are described in the following with reference to the attached drawings, which schematically show in:

Figure 1:     an MRI device according to an embodiment of the invention;

Figure 2:     a magnetic field modulation source device included in an MRI device according to an embodiment of the invention;

Figure 3:     an overview of magnetic field patterns created with the magnetic field modulation source device of Figure 2;

Figure 4:     an illustration of free induction decay acquired at a constant main magnetic field and with a varying magnetic modulation field;

Figure 5:     an illustration of effects of the varying magnetic modulation field on the spatial encoding; and

Figures 6 and 7:     illustrations of the invention based on the concept of generating virtual phase-shifted images by varying magnetic modulation fields.

Figure 8: an illustration of effects of the varying magnetic modulation field from each individual coil on the spatial encoding;

Figure 9: an illustration of effects of the varying magnetic modulation field from 8 coils on the spatial encoding without acceleration, and the result of the reconstruction;

Figure 10: an illustration of effects of the varying magnetic modulation field from 8 coils on the spatial encoding with 2X acceleration, and the result of the reconstruction; and

Figure 11: an illustration of the singular value spectrum of the encoding matrix in case no locally specific frequency modulation is applied versus the modulation according to the invention.

Detailed description of preferred embodiments of the invention

Embodiments of the invention are described in the following with particular reference to the inventive locally specific frequency modulation of MR signals by means of at least one spatially restricted, time-varying magnetic modulation field. The invention preferably is implemented with an MR scanner as it is known per se. Accordingly, details of the MR scanner, the available control schemes thereof and available schemes of MR signal acquisition are not described as they are known from prior art. Exemplary reference is made to applications of the invention, wherein a magnetic field modulation source device comprises an arrangement of local magnetic field coils. The invention is not restricted to this embodiment, but correspondingly can be implemented with one single local magnetic field coil and/or with a shimming device comprising at least one local spherical harmonic shim coil. In particular, one single local magnetic field coil or one local spherical harmonic shim coil, e. g. covering a half of the object under investigation, is sufficient for providing additional spatial information for image reconstruction.

Embodiments of the MRI device and method

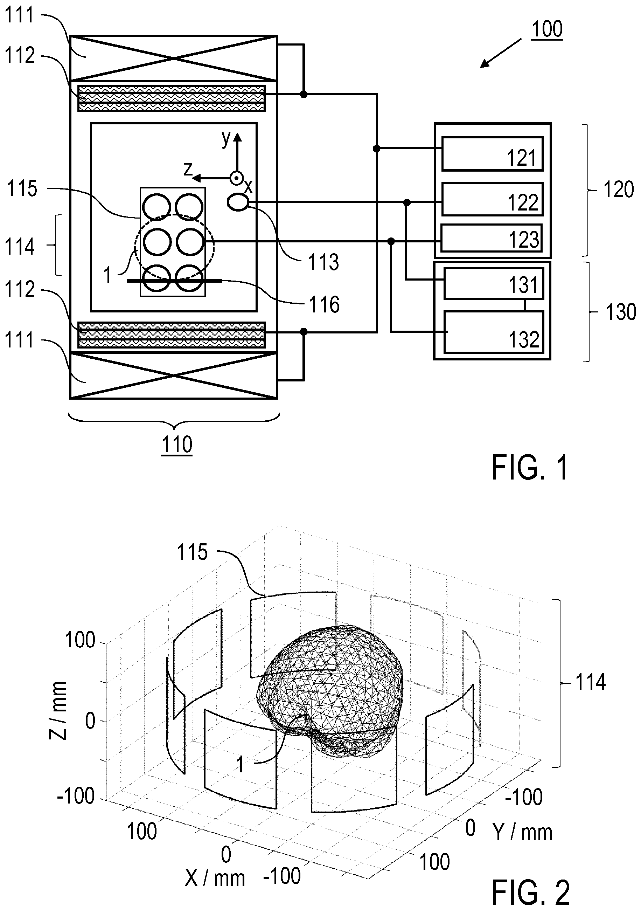

Figure 1 schematically illustrates an embodiment of an MRI device 100 including an MR scanner 110, a control device 120 and a reconstruction device 130, which are configured for implementing the invention. The MR scanner 110 includes a main magnetic field device 111, a magnetic gradient device 112, an excitation/acquisition coil device 113 and a magnetic field modulation source device 114. Furthermore, a schematically illustrated holding device 116, like a supporting table, can be provided for supporting an object 1 to be investigated. The components 111 to 113 and 116 are configured as it is known from conventional MR scanners. For example, the excitation/acquisition coil device 113 can comprise a single RF coil or an array of RF coils arranged for parallel MR imaging.

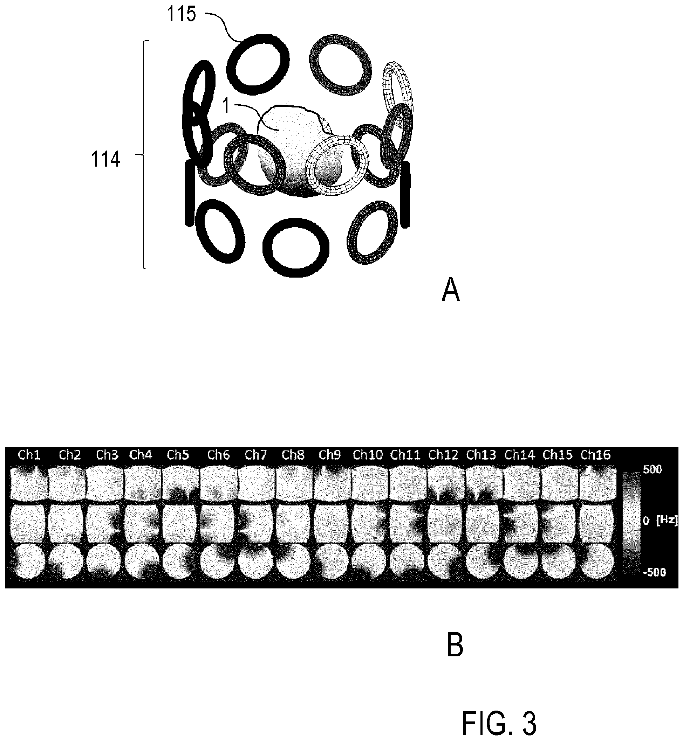

The magnetic field modulation source device 114 is adapted for creating preferably less than 130 e. g. 10 to 30, spatially restricted, time-varying magnetic modulation fields, each covering a spatial section of the object 1. Magnetic field coils 115 of the magnetic field modulation source device 114, e. g. a set of surface coil loop elements, are designed such each magnetic field sufficiently covers the extension of the spatial section of the object to which the modulation is to be applied. Preferably, magnetic field coils 115 are arranged on at least two different sides of the object 1. Examples of the magnetic field modulation source device 114 are described below with reference to Figures 2 and 3.

The control device 120 includes a main field and gradient control unit 121, an RF pulse control unit 122 and a modulation source control unit 123, each including driving circuits, like excitation and modulation current sources, amplifiers and/or pulse modulators, and at least one computer unit. The components 121 to 123 can be provided with a common computer unit or with separate computer units, coupled with the driving circuits for driving the components 111 to 114. In particular, the modulation source control unit 123 is connected with the magnetic field modulation source device 114 for creating the inventive locally specific frequency modulation of the MR signals. The reconstruction device 130 includes a signal acquisition device 131 coupled with the excitation/acquisition coil device 113 and a calculation device 132. Optionally, the calculation device 132 can be coupled, e. g. via direct connection or any other type of data transmission, with the modulation source control unit 123, so that information on the modulation pattern applied to the magnetic field modulation source device 114 can be introduced in the MR image reconstruction. The components 131 and 132 can be provided with a common computer unit or with separate computer units. The computer units of the control device 120 and the reconstruction device 130 are adapted for running software controlling the setting of the components 111 to 114, for collecting and processing MR signals and for MR image reconstruction, resp..

Figure 2 shows an example of a magnetic field modulation source device 114, which comprises 8 independent local magnetic field coils 115 (schematically shown) that are placed in one circular row perpendicular to the z-direction on a hollow cylinder shaped non-conductive carrier (not shown). With a preferred application of the invention, the object 1 to be investigated, for example a head of a human subject, is placed inside this arrangement (as mentioned with reference to the experimental tests below). Each local magnetic field coil 115 is made of e. g. 25 turns of copper wire with a coil diameter of 5 cm to 10 cm. Each coil is independently connected to an individually controllable modulation current source of the modulation source control unit 123 (see Figure 1) that allows to drive the modulation current in each coil with preselected and independent, different temporal patterns during MR signal collection, e. g. during read-out of a FLASH sequence or another sequence.

The arrangement of Figure 2 can be modified, e. g. by providing two circular rows of local magnetic field coils 115 perpendicular to the z-axis surrounding a hollow cylinder as schematically shown in Figure 3A. With this embodiment, the magnetic field modulation source device 114 comprises 16 independent local magnetic field coils 115.

The inventive spatial encoding relies on injecting oscillating currents into the local magnetic field coils 115. For example, a sine-form modulation can be used in each coil loop element, where all coil elements share the same modulation frequency but have distinct phases. The technique allows to use characteristic spatiotemporal patterns of field variations due to oscillating currents during image reconstruction in order to improve SNR or accelerate the acquisition. An extra information required to solve a potentially under-determined underlying system of linear equations can be obtained by increasing the number of samples acquired in each readout.

With more details, according to the waveform of the modulation current, the local magnetic field coils 115 induce local and varying magnetic fields in the object 1, each having a field component parallel to the main magnetic field (z-direction) of the MR scanner. Each of the local magnetic field coils 115 produces a local field having an amplitude and local and temporal distribution according to Biot-Savart law. The local field deviates from the originally homogeneous main magnetic field into positive or negative direction. An example is shown in Figure 3B, which shows an overview of the magnetic field patterns (in units of Hz) generated by a constant current through coils 1 to 16 in a cylindrical phantom object placed inside the cylinder shown in Figure 3A. Figure 3B can be considered as a snap-shot of a time-varying specific spatially confined magnetic field pattern in the object 1, which is illustrated along three Cartesian spatial directions for each individual coil.

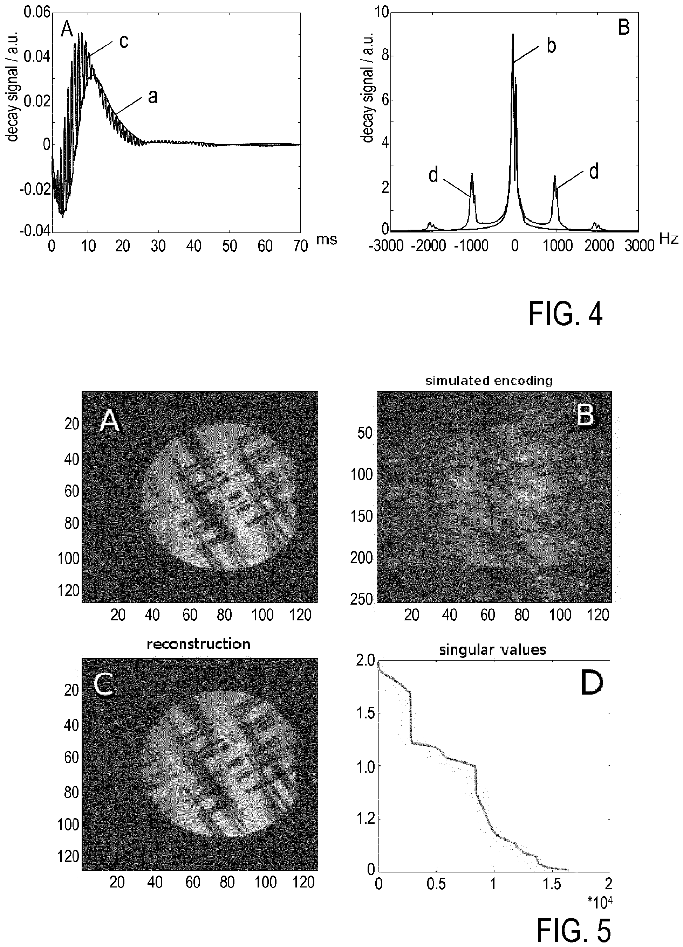

The distinct magnetic field pattern generated by each individual coil is used for local spatial encoding. The principle of the invention is to apply temporal varying currents independently to each of the local magnetic field coils 115 during the acquisition of the MR signal. A temporal current variation induces a local varying magnetic field that modifies the local Larmor frequency of the magnetization which is sensed with the excitation/acquisition coil device 113. Figure 4 shows an example where a sinusoidal current is applied to one coil element 115 (1 kHz at 1 A) during the acquisition of a free induction decay. In this example, this current produces a 1 kHz varying local magnetic field that generates a locally confined oscillation of the free induction decay (scale of decay signal axes: a.u.). The smooth curve a of Figure 4A shows a free induction decay acquired at a constant magnetic field without applying any currents to the local magnetic field coils 115.

Figure 4B shows the corresponding spectrum with a peak b around 0 Hz. Application of the varying magnetic modulation field of 1 kHz via the local coil 115 superimposes an oscillation onto the free induction decay (curve c in Figure 4A). This produces 1 kHz separated side lobes d in the corresponding spectra shown in Figure 4B, thus providing the additional spatial image information for the reconstruction of the MR signals.

Preferably, currents with different frequencies and/or phases are applied to each coil separately during the acquisition of the MR signal. Based on these locally different modulations introduced by the magnetic modulation field, the spatial origin of the acquired MR signal can be localized by the mathematical reconstruction procedures. With this additional spatial image information, the MR imaging process is accelerated.

The mathematical reconstruction procedure may comprise the reconstruction of local images associated to the side lobes shown in Figure 4B and the subsequent superposition of the local images. Alternatively, the reconstruction may comprise a numerical optimization as outlined below.

Image reconstruction by numerical optimization

In the following, the model of the image acquisition is specified, which is preferably used for image reconstruction. With this example, the reconstruction employs the assumption that an MR signal acquisition is performed using a single receive coil element of the excitation/acquisition coil device 113, which has a complex-valued sensitivity profile $B_1(r)$. If the MR signal acquisition is performed using multiple receive coil element, the reconstruction is extended as outlined below. Without loss of generality, relaxation effects are ignored in the present example model, and spatial encoding terms are considered.

Signals $S$ acquired at time $t$ and providing the spectrum $s$ can be obtained via the integration over the excited volume.

$$S(\boldsymbol{k},t) = \iiint \boldsymbol{m}(\boldsymbol{r})\boldsymbol{B}_1(\boldsymbol{r})\exp(-i(\boldsymbol{k}(\boldsymbol{r},t) + \boldsymbol{B}_c(\boldsymbol{r})\int_{t_1}^{t} f_c(\boldsymbol{r},\tau)d\tau))dxdydz$$

$$k(r, t) = \int_0^t G(r, \tau) d\tau$$

where .

The phase of the exponential term is composed of two parts. The term $k(r, t)$ describes spatial linear gradients that are used to perform frequency and phase encoding ($G$: linear gradient vector, $r$: spatial vector, $\tau$: time, and $t$: time point of signal acquisition). Finally, the second term $B_c(r) \int_{t_1}^t f_c(r, \tau) d\tau$ corresponds to a field induced by the local magnetic field coils 115 subject to an arbitrary waveform $f_c$. $B_0$ field profile of the coil element c in z-direction is indicated by $B_c$, $m(r)$ is the object image to be reconstructed. Furthermore, $t_1$ indicates the beginning of the modulation. With the second term, the additional spatial image information of the spatially encoded magnetic resonance signals is provided. In general, other temporally varying patters can be applied.

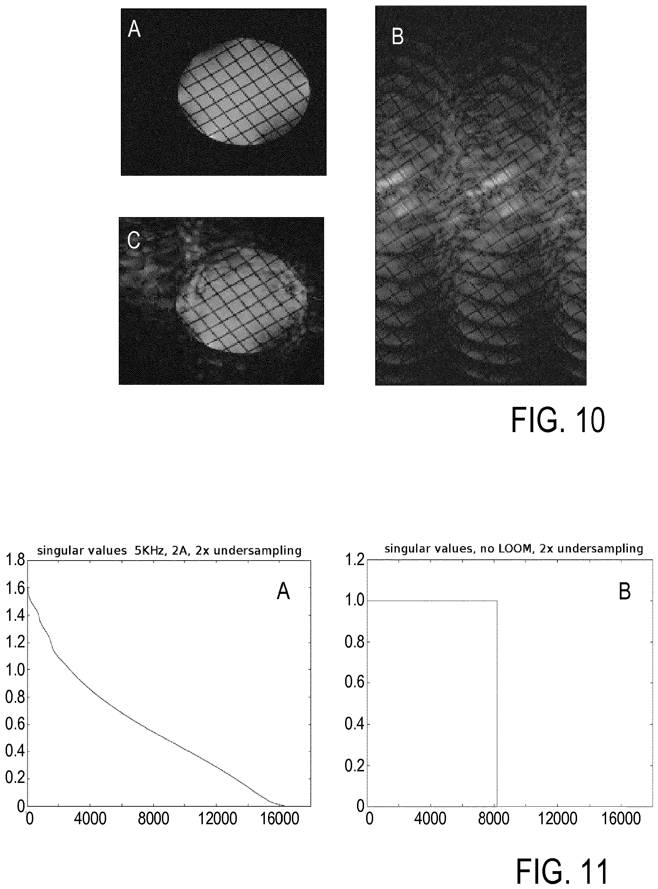

The reconstruction results shown in Figure 10 and Figure 11 were obtained by discretizing the continuous model and assuming a sinusoidal waveform. With 2D acquisition protocol, $K_x$, $K_y$ are the number of acquired k-space lines in readout and phase-encode directions, respectively, and $N_x$, $N_y$ he number of pixels in spatial domain in read-out/phase-encode directions, the complex-valued spectrum $s \in \mathbb{C}^{K_x \times K_y}$ is acquired. From the spectrum $s$, the complex-valued image $m \in \mathbb{C}^{N_x \times N_y}$ is to be reconstructed in the spatial domain. The image $m$ is reconstructed by a numerical optimization procedure. The image acquisition process employed with the inventive imaging method can be described by a discrete linear operator $E \in \mathbb{C}^{(K_x K_y) \times (N_x N_y)}$. The acquisition process is thus given by a linear equation $s = Em$. In case the currents injected into the local magnetic field coils are zero, the encoding matrix is an orthonormal Fourier transform matrix $E = F$. For ease of indexing the encoding matrix can be reshaped as $E \in \mathbb{C}^{K_x \times K_y \times N_x \times N_y}$. With injecting currents into the local magnetic field coils and the inventive encoding, the elements of the encoding matrix $E$ are given by:

$$E_{i,j,l,m} = F_{i,j,l,m} \exp\left(-\sqrt{-1} \frac{\sum_c (a_c B_{c,l,m} \cos(2\pi w \tau_i + \theta_c))}{w}\right)$$

Here, $i, j$ are the indices of the acquired k-space lines in readout and phase encode direction. Indices $l, m$ are the spatial coordinates. $F_{i,j,l,m}$ are the elements of the Fourier transform matrix, $B_c \in \mathbb{C}^{C \times N_x \times N_y}$ is the $B_0$ field profile in z-direction of a local magnetic field from coil $c$, $\omega$ is the frequency of the inventive local modulation, $\alpha_c$ is the current amplitude, $\theta_c$ is the phase offset of the modulation, and $\tau_i$ is the time vector.

It is assumed that there are no off-resonance field components and $B_0 = 0$. In case the injected currents $a_c$ are non-zero, in order to reconstruct the image $m$ the linear system $s = Em$ is solved by computing a pseudoinverse of the encoding matrix $E$ or by a numerical optimization. Here, $E$ is the above linear operator that aggregates the exponential encoding terms and performs the summation (integration) over the spatial domain.

In MR signal acquisitions with geometry factors (g factor) close to unity, computing the pseudoinverse of the encoding matrix $E$ and applying it to the measured k-space allows for a simple one-shot reconstruction. Otherwise, in case the g factor is greater than unity, inversion of the system can be unstable and results noisy. In this case, a modified least absolute shrinkage and selection operator (LASSO) optimization can be employed. The vanilla LASSO is modified such that in the regularizer term a total variation (L1 norm of the voxel differences in X/Y in spatial domain) is used instead of the plain L1 norm (as in usual LASSO). Total variation loss puts a high penalty on residual artifacts from the inventive encoding, which appear as blur and readout direction-smeared-out image content. The following regularized optimization problem is solved:

$$\hat{m} = argmin_m(||Em - s||_2^2 + \lambda |Dm|_1)$$

The regularization coefficient $\lambda$ sets the weight of the total variation term that penalizes highfrequency artifacts in the reconstruction. With the matrix $D$, finite pixel difference of the reconstructed image $m$ is computed in spatial domain.

A computationally intensive part in the optimization loop is the repetitive multiplications with the encoding matrix $\boldsymbol{E}$, which can either be pre-computed and stored in memory, or generated online. In the latter case, the operation can be efficiently performed on GPUs, since it relies on computing a massive number of independent complex-valued weighting coefficients subject to spatial location.

An extension of the model to the case of accelerated acquisition is straightforward and involves decreasing the number of rows in the matrix $\boldsymbol{E}$ subject to the k-space undersampling pattern.

Simulation results

Figure 5 (A, B, C - scale axes: pixel number) illustrates effects of the oscillating modulation current on the spatial encoding. For the reconstruction of simulated data, $C$=16 coil loops, a modulation frequency of 17 kHz, a current amplitude of 10A are employed. Figure 5A shows the simulated object to be imaged. An accelerated acquisition by keeping every 2nd k-space line and additionally keeping 4 central k-space lines around the DC component is assumed for the simulation. The sine form in each of the coil loops has a phase equal to $\frac{2\pi c}{C}$, where c is the coil loop index. Figure 5B shows the image as reconstructed with an inverse Fourier transform without taking into account additional field terms of inventive modulation. Figure 5C shows the inventive reconstruction of an object image obtained by solving the above linear system. Figure 5D shows a spectrum of singular values of the encoding matrix $\mathbf{E}$.

In case multiple receive elements $V$ of the excitation/acquisition coil device 113 are employed the model is extended to:

$$S(\boldsymbol{k}, t, \nu) = \iiint \boldsymbol{m}(\boldsymbol{r}) \boldsymbol{B}_{1,\nu}(\boldsymbol{r}) \exp(-i(\boldsymbol{k}(\boldsymbol{r}, t) + \boldsymbol{B}_c(\boldsymbol{r}) \int_{t_1}^{t} f_c(\boldsymbol{r}, \tau) d\tau)) dx dy dz$$

The reconstruction problem is still formulated in terms of solution of $\boldsymbol{s} = \boldsymbol{Em}$, system, where both $\mathbf{s}$ and $\mathbf{E}$ now have additional rows originating from respective receive coil elements.

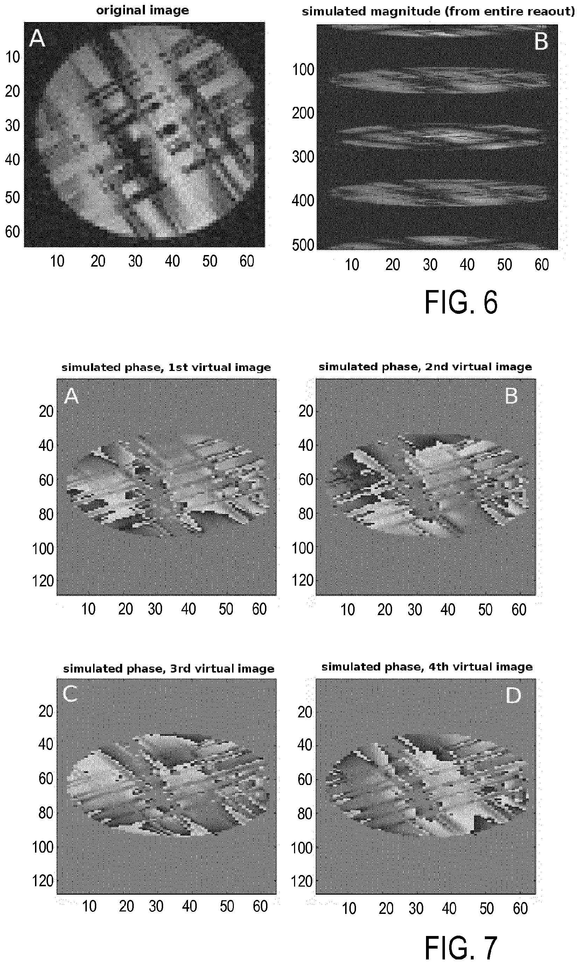

The image formation and reconstruction alternatively can be described with the concept of generating virtual phase-shifted images by the varying magnetic modulation fields as illustrated in Figures 6 and 7 (scale axes: pixel number). Each of the local magnetic field coils 115 modulates the MR signals in a restricted spatial section of the object, e. g. in 16 sections of the object 1 penetrated by the magnetic fields of the local magnetic field coils 115 (see Figure 2). Accordingly, in each spatial section of the object, specific MR signals are locally collected. The MR signals are shifted in frequency space relative to the radiofrequency range of the unmodulated MR signals by the local modulation frequency as shown in Figure 4B. MR signals from the different spatial sections provide virtual MR images with equal amplitudes but different phases. Accordingly, one or several sets of virtual images from the object are produced by the local frequency modulated magnetic fields. Based on a simulated object as shown in Figure 6A, those virtual images are obtained as shown in Figures 6B and 7. In the step of image reconstruction, the virtual images and the information on the spatial origin thereof are used as additional local information.

Experimental test results

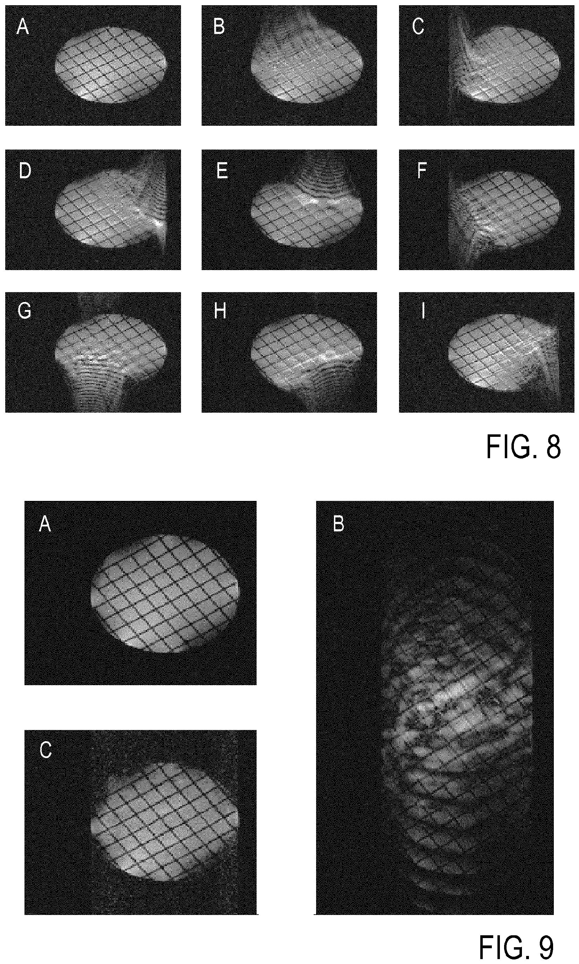

Figures 8 to 11 illustrated results of practical experiments performed on a whole body 9.4T MR scanner on a cylinder-shaped phantom filled with silicon oil. The experimental setup employed eight local magnetic field coils for the inventive magnetic field modulations. The eight local coils were arranged like one of the circular coil rows as shown in Figure 2. For excitation and reception of the MR signal a patch antenna (see excitation/acquisition coil device 113 in Figure 1) placed about 10 cm away from the phantom was used. The oil phantom was placed inside a larger hollow cylinder carrying the eight local magnetic field coils.

In a first test step, no currents have been applied to the eight local coils. A gradient echo sequence was used to image one slice of the oil phantom as shown in Figure 8A (reference). Next, an alternating current of 2A (zero-peak) and 1 kHz has been applied for only one of the local magnetic field coils (one single channel), and repeated for each local magnetic field coil separately. The alternating current was applied only during the readout period of each k-space line acquisition during the gradient echo sequence. Figures 8B to 8I (channels 1 to 8) show the resulting local image distortions and modulations. No reconstruction algorithm was applied except of a plain Fourier transformation of the k-space data.

Next, an alternating current of 2A and 5 kHz was applied to all channels with a phase shift of 45° between all channels during each readout period of the gradient echo sequence. Figure 9A (reference) shows the reference image without application of currents. Figure 9B shows the resulting image modulations if only a plain Fourier transformation has been applied to the k-space data. Figure 9C shows the object image reconstructed via the described method by inversion of the corresponding linear imaging equation. The spatial distribution of local magnetic fields produced by each single magnetic field coil has been measured before, and have been used to setup the matrix $E$ in the linear imaging equation. This example shows that a complete reconstruction is possible using the described approach. However, in this example the local field modulations have not been used to accelerate the imaging process.

Figure 10 shows an example where the local field modulations have been used to accelerate image acquisition with twofold undersampling. Figure 10A (reference) represents the reference image. In Figure 10B, again alternating currents of 2A and 5 kHz were applied to all channels with a phase shift of 45° between all channels during each readout period of the gradient echo sequence. In contrast to Figure 9B, in Figure 10B only every other k-space line was acquired and thus image acquisition time was reduced by a factor of two. Figure 10C shows the object image reconstructed via the described method by inversion of the corresponding linear imaging equation, but only using half of the sampled k-space lines as compared to Figure 9. This example proves the basic acceleration advantage of the invention.

Figure 11 shows an example of the singular values of the imaging encoding matrix $E$ for the experimental test in Figure 10 with two-fold undersampling in phase-encode direction, in case no locally specific frequency modulation is applied versus the modulation with 8 coils at 5 kHz and 2A. Figure 11A is with the application of alternating currents. Without application of alternating currents to the magnetic field coils (Figure 11B) the upper half of singular values is zero, the matrix is rank-deficient and thus no reconstruction would be possible for two-fold k-space undersampling.

The features of the invention disclosed in the above description, the drawings and the claims can be of significance both individually as well as in combination or sub-combination for the realization of the invention in its various embodiments.

## Claims

1. Method of magnetic resonance tomography (MRT) imaging an object (1), comprising the steps of:

   - arranging the object (1) in a static magnetic field of a magnetic resonance scanner (110),
   - subjecting the object (1) to at least one radiofrequency pulse and magnetic field gradients for creating spatially encoded magnetic resonance signals,
   - collecting magnetic resonance signals, wherein the collecting step includes a phase-encoding step and a readout period, and
   - reconstructing an object image, wherein the spatial encoding of the magnetic resonance signals is utilized,

   **characterized in that**

   - only during the readout period, the magnetic resonance signals are subjected to a locally specific frequency modulation by means of at least one spatially restricted, time-varying magnetic modulation field, which has a component parallel to the static magnetic field and which has a modulation frequency being selected such that a temporal frequency modulation of the local Larmor frequencies of the magnetization is obtained, and
   - the step of reconstructing the object image further utilizes the locally specific frequency modulation for obtaining spatial information from the spatially encoded magnetic resonance signals.

2. MRT imaging method according to claim 1, wherein

   - the at least one spatially restricted, time-varying magnetic modulation field has a modulation frequency of at least 100 Hz and/or at most 10 MHz.

3. MRT imaging method according to one of the foregoing claims, wherein

   - the at least one spatially restricted, time-varying magnetic modulation field has a sinusoidal or triangular modulation shape.

4. MRT imaging method according to one of the foregoing claims, wherein the at least one spatially restricted, time-varying magnetic modulation field is created with at least one of

   - at least one local magnetic field coil being arranged adjacent to the object (1), and
   - a shimming device comprising spherical harmonic shim coils being arranged for shimming a magnetic field distribution in the object (1).

5.  MRT imaging method according to one of the foregoing claims, wherein

    - the static magnetic field is superimposed during the readout period with at least two spatially restricted, time-varying magnetic modulation fields being localized in different spatial sections of the object (1).

6.  MRT imaging method according to claim 5, wherein

    - the spatially restricted, time-varying magnetic modulation fields in different spatial sections of the object (1) have different amplitudes, frequencies, phases and/or modulation shapes.

7.  MRT imaging method according to one of the foregoing claims, including a step of

    - selecting the number and/or extension of spatial sections of the object (1) being subjected to different spatially restricted, time-varying magnetic modulation fields in dependency on operation instructions provided by an operator and/or a preliminary object imaging process.

8.  MRT imaging method according to one of the foregoing claims, wherein the step of collecting the magnetic resonance signals includes at least one of

    - parallel sensing the magnetic resonance signals with a plurality of RF coils, and
    - changing the at least one spatially restricted, time-varying magnetic modulation field for each phase encoding step included in the step of collecting the magnetic resonance signals.

9.  MRT imaging method according to one of the foregoing claims, wherein

    - the step of reconstructing the object image $m$ includes solving a linear equation system $s = E\,m$ by a regularized optimization, wherein $s$ includes the magnetic resonance signals and $E$ is an encoding matrix being determined by the spatial encoding of the magnetic resonance signals and depending on time-varying modulation components.

10. Magnetic resonance imaging (MRI) device (100), including

    - a magnetic resonance scanner (110) being configured for accommodating an object (1) to be imaged, creating a static magnetic field, at least one radiofrequency pulse and magnetic field gradients, subjecting the object (1) to the at least one radiofrequency pulse and magnetic field gradients for creating spatially encoded magnetic resonance signals, and collecting magnetic resonance signals, wherein the collecting step includes a phase-encoding step and a readout period,
    - a control device (120) being configured for controlling the magnetic resonance scanner, and
    - a reconstruction device (130) being configured for reconstructing an object image based on the magnetic resonance signals,

    **characterized in that**

    - the magnetic resonance scanner (110) includes a magnetic field modulation source device (114), which is further adapted for superimposing the static magnetic field with at least one spatially restricted, time-varying magnetic modulation field, which has a component parallel to the static magnetic field and which has a modulation frequency being selected such that a temporal frequency modulation of the local Larmor frequencies of the magnetization is obtained, so that the magnetic resonance scanner is adapted for subjecting the magnetic resonance signals to a locally specific frequency modulation only during the readout period of the collecting step of the magnetic resonance signals,
    - the control device (120) is configured for setting the at least one spatially restricted, time-varying magnetic modulation field, and
    - the reconstruction device (130) is configured for reconstructing the object image by utilizing the locally specific frequency modulation of the magnetic resonance signals for obtaining spatial image information from the spatially encoded magnetic resonance signals.

11. MRI device according to claim 10, which is adapted for conducting the MRT imaging method according to one of the claims 2 to 9.

**Patentansprüche**

1. Verfahren zur Magnetresonanztomographie-(MRT)-Bildgebung eines Objekts (1) abbildet, aufweisend die Schritte:

    - Anordnen des Objekts (1) in einem statischen Magnetfeld eines Magnetresonanz-Scanners (110),
    - Beaufschlagen des Objekts (1) mit mindestens einem Hochfrequenzimpuls und Magnetfeldgradienten zum Erzeugen von räumlich kodierten Magnetresonanzsignalen,
    - Sammeln von Magnetresonanzsignalen, wobei der Sammelschritt einen Phasencodierungsschritt und eine Ausleseperiode umfasst, und
    - Rekonstruieren eines Objektbildes, wobei die räumliche Kodierung der Magnetresonanzsignale verwendet wird,

    **dadurch gekennzeichnet, dass**

    - nur während der Ausleseperiode die Magnetresonanzsignale einer ortsspezifischen Frequenzmodulation unterworfen werden mittels mindestens eines räumlich begrenzten, zeitlich variierenden magnetischen Modulationsfeldes, das eine zum statischen Magnetfeld parallele Komponente aufweist und das eine Modulationsfrequenz aufweist, die so gewählt ist, dass sich eine zeitliche Frequenzmodulation der lokalen Larmor-Frequenzen der Magnetisierung ergibt, und
    - der Schritt des Rekonstruierens des Objektbildes weiterhin die ortsspezifische Frequenzmodulation zum Erhalten von räumlichen Informationen aus den räumlich kodierten Magnetresonanzsignalen nutzt.

2. MRT-Bildgebungs-Verfahren nach Anspruch 1, wobei

    - das mindestens eine räumlich begrenzte, zeitlich variierende magnetische Modulationsfeld eine Modulationsfrequenz von mindestens 100 Hz und/oder höchste ns 10 MHz aufweist.

3. MRT-Bildgebungs-Verfahren nach einem der vorangehenden Ansprüche, wobei

    - das mindestens eine räumlich begrenzte, zeitlich variierende magnetische Modulationsfeld eine sinusförmige oder dreieckige Modulationsform aufweist.

4. MRT-Bildgebungs-Verfahren nach einem der vorangehenden Ansprüche, wobei das mindestens eine räumlich begrenzte, zeitlich variierende magnetische Modulationsfeld erzeugt wird mit mindestens einem von:

    - mindestens einer lokalen Magnetfeldspule, die neben dem Objekt (1) angeordnet ist, und
    - einer Abgleicheinrichtung mit kugelförmigen, harmonischen Abgleichspulen, die zum Abgleich einer Magnetfeld-Verteilung in dem Objekt (1) angeordnet ist.

5. MRT-Bildgebungs-Verfahren nach einem der vorangehenden Ansprüche, wobei

    - das statische Magnetfeld während der Ausleseperiode mit mindestens zwei räumlich begrenzten, zeitlich variierenden magnetischen Modulationsfeldern überlagert wird, die in verschiedenen räumlichen Abschnitten des Objekts (1) angeordnet sind.

6. MRT-Bildgebungs-Verfahren nach Anspruch 5, wobei

    - die räumlich begrenzten, zeitlich variierenden magnetischen Modulationsfelder in unterschiedlichen räumlichen Abschnitten des Objekts (1) unterschiedliche Amplituden, Frequenzen, Phasen und/oder Modulationsformen aufweisen.

7. MRT-Bildgebungs-Verfahren nach einem der vorangehenden Ansprüche, aufweisend einen Schritt eines

    - Auswählens der Anzahl und/oder der Ausdehnung von räumlichen Abschnitten des Objekts (1), die unterschiedlichen räumlich begrenzten, zeitlich variierenden magnetischen Modulationsfeldern ausgesetzt sind, in Abhängigkeit von Bedienanweisungen, die von einem Bediener bereitgestellt werden, und/oder einem vorbereitenden Objektabbildungsprozess.

**8.** MRT-Bildgebungs-Verfahren nach einem der vorangehenden Ansprüche, wobei der Schritt des Sammelns der Magnetresonanzsignale mindestens einen der folgenden Schritte umfasst:

- Paralleles Abtasten der Magnetresonanzsignale mit einer Mehrzahl von HF-Spulen, und
- Ändern des mindestens einen räumlich begrenzten, zeitlich variierenden magnetischen Modulationsfeldes für jeden Phasencodierungsschritt, der in dem Schritt des Sammelns der Magnetresonanzsignale enthalten ist.

**9.** MRT-Bildgebungs-Verfahren nach einem der vorangehenden Ansprüche, wobei

- der Schritt des Rekonstruierens des Objektbildes $m$ das Lösen eines linearen Gleichungssystems $s = E\,m$ durch eine regulierte Optimierung umfasst, wobei $s$ die Magnetresonanzsignale umfasst und $E$ eine Kodiermatrix ist, die durch die räumliche Kodierung der Magnetresonanzsignale bestimmt wird und von zeitlich variierenden Modulationskomponenten abhängt.

**10.** Magnetresonanz-Bildgebungs-(MRI)-Vorrichtung (100), umfassend

- einen Magnetresonanz-Scanner (110), der konfiguriert ist zum Unterbringen eines abzubildenden Objekts (1), zum Erzeugen eines statischen Magnetfelds, mindestens eines Hochfrequenzimpulses und Magnetfeldgradienten, zum Beaufschlagen des Objekts (1) mit dem mindestens einen Hochfrequenzimpuls und Magnetfeldgradienten, um räumlich kodierte Magnetresonanzsignale zu erzeugen, und Magnetresonanzsignale zu sammeln, wobei der Sammelschritt einen Phasencodierungsschritt und eine Ausleseperiode umfasst,
- eine Steuereinrichtung (120), die zum Steuern des Magnetresonanz-Scanners konfiguriert ist, und
- eine Rekonstruktionseinrichtung (130), die zum Rekonstruieren eines Objektbildes auf der Grundlage der Magnetresonanzsignale konfiguriert ist,

**dadurch gekennzeichnet, dass**

- der Magnetresonanz-Scanner (110) eine Magnetfeld-Modulationsquellen-Einrichtung (114) enthält, die ferner dazu eingerichtet ist, das statische Magnetfeld mit mindestens einem räumlich begrenzten, zeitlich variierenden magnetischen Modulationsfeld zu überlagern, das eine zum statischen Magnetfeld parallele Komponente aufweist und das eine Modulationsfrequenz aufweist, die so gewählt ist, dass sich eine zeitliche Frequenzmodulation der lokalen Larmor-Frequenzen der Magnetisierung ergibt, so dass der Magnetresonanz-Scanner eingerichtet ist, die Magnetresonanzsignale nur während der Ausleseperiode des Sammelschritts der Magnetresonanzsignale einer ortsspezifischen Frequenzmodulation auszusetzen,
- die Steuereinrichtung (120) zum Einstellen des mindestens einen räumlich begrenzten, zeitlich variierenden magnetischen Modulationsfeldes ausgebildet ist, und
- die Rekonstruktionseinrichtung (130) zum Rekonstruieren des Objektbildes unter Verwendung der ortsspezifischen Frequenzmodulation der Magnetresonanzsignale zum Erhalten räumlicher Bildinformationen aus den räumlich kodierten Magnetresonanzsignalen ausgebildet ist.

**11.** MRI-Vorrichtung nach Anspruch 10, die zum Durchführen des MRT-Bildgebungs-Verfahrens nach einem der Ansprüche 2 bis 9 eingerichtet ist.

**Revendications**

**1.** Procédé d'imagerie par tomographie par résonance magnétique (TRM) d'un objet (1), comprenant les étapes consistant à :

- agencer l'objet (1) dans un champ magnétique statique d'un scanner à résonance magnétique (110),
- soumettre l'objet (1) à au moins une impulsion radiofréquence et à des gradients de champ magnétique pour créer des signaux de résonance magnétique spatialement codés,
- collecter des signaux de résonance magnétique, dans lequel l'étape de collecte comporte une étape de codage de phase et une période de lecture, et

- reconstruire une image d'objet, dans lequel le codage spatial des signaux de résonance magnétique est utilisé,

**caractérisé en ce que**

- uniquement pendant la période de lecture, les signaux de résonance magnétique sont soumis à une modulation de fréquence localement spécifique au moyen d'au moins un champ de modulation magnétique variable dans le temps et spatialement restreint, qui possède une composante parallèle au champ magnétique statique et qui possède une fréquence de modulation qui est sélectionnée de sorte qu'une modulation de fréquence temporelle des fréquences de Larmor locales de l'aimantation soit obtenue, et
- l'étape consistant à reconstruire l'image d'objet utilise en outre la modulation de fréquence localement spécifique pour obtenir des informations spatiales provenant des signaux de résonance magnétique spatialement codés.

2. Procédé d'imagerie par TRM selon la revendication 1, dans lequel

- l'au moins un champ de modulation magnétique variable dans le temps et spatialement restreint possède une fréquence de modulation d'au moins 100 Hz et/ou d'au plus 10 MHz.

3. Procédé d'imagerie par TRM selon l'une des revendications précédentes, dans lequel

- l'au moins un champ de modulation magnétique variable dans le temps et spatialement restreint possède une forme de modulation sinusoïdale ou triangulaire.

4. Procédé d'imagerie par TRM selon l'une des revendications précédentes, dans lequel l'au moins un champ de modulation magnétique variable dans le temps et spatialement restreint est créé avec au moins l'un parmi

- au moins une bobine de champ magnétique local qui est agencée de manière adjacente à l'objet (1), et
- un dispositif de compensation comprenant des bobines de compensation harmonique sphériques qui sont agencées pour la compensation d'une distribution de champ magnétique dans l'objet (1).

5. Procédé d'imagerie par TRM selon l'une des revendications précédentes, dans lequel

- le champ magnétique statique est superposé pendant la période de lecture avec au moins deux champs de modulation magnétique variables dans le temps et spatialement restreints qui sont localisés dans différentes sections spatiales de l'objet (1).

6. Procédé d'imagerie par TRM selon la revendication 5, dans lequel

- les champs de modulation magnétique variables dans le temps et spatialement restreints dans différentes sections spatiales de l'objet (1) possèdent des amplitudes, des fréquences, des phases et/ou des formes de modulation différentes.

7. Procédé d'imagerie par TRM selon l'une des revendications précédentes, comportant une étape consistant à

- sélectionner le nombre et/ou l'extension de sections spatiales de l'objet (1) qui sont soumises à différents champs de modulation magnétique variables dans le temps et spatialement restreints en dépendance d'instructions opérationnelles fournies par un opérateur et/ou un processus d'imagerie d'objet préliminaire.

8. Procédé d'imagerie par TRM selon l'une des revendications précédentes, dans lequel l'étape consistant à collecter des signaux de résonance magnétique comporte au moins l'une parmi

- la détection parallèle des signaux de résonance magnétique avec une pluralité de bobines RF, et
- la modification de l'au moins un champ de modulation magnétique variable dans le temps et spatialement restreint pour chaque étape de codage de phase comprise dans l'étape consistant à collecter des signaux de résonance magnétique.

9. Procédé d'imagerie par TRM selon l'une des revendications précédentes, dans lequel

- l'étape consistant à reconstruire l'image d'objet m comporte la résolution d'un système d'équations linéaires s = E m par une optimisation régularisée, dans lequel s comporte les signaux de résonance magnétique et E est une matrice de codage qui est déterminée par le codage spatial des signaux de résonance magnétique et dépendante de composantes de modulation variables dans le temps.

10. Dispositif (100) d'imagerie par résonance magnétique (IRM), comportant

- un scanner à résonance magnétique (110) qui est configuré pour accueillir un objet (1) devant être imagé, créer un champ magnétique statique, au moins une impulsion radiofréquence et des gradients de champ magnétique, soumettre l'objet (1) à l'au moins une impulsion radiofréquence et aux gradients de champ magnétique pour la création de signaux de résonance magnétique spatialement codés, et collecter des signaux de résonance magnétique, dans lequel l'étape de collecte comporte une étape de codage de phase une période de lecture,
- un dispositif de commande (120) qui est configuré pour la commande du scanner à résonance magnétique, et
- un dispositif de reconstruction (130) qui est configuré pour la reconstruction d'une image d'objet sur la base des signaux de résonance magnétique,

**caractérisé en ce que**

- le scanner à résonance magnétique (110) comporte un dispositif source de modulation de champ magnétique (114), qui est en outre adapté pour superposer le champ magnétique statique avec au moins un champ de modulation magnétique variable dans le temps et spatialement restreint, qui possède une composante parallèle au champ magnétique statique et qui possède une fréquence de modulation qui est sélectionnée de sorte qu'une modulation de fréquence temporelle des fréquences de Larmor locales de l'aimantation soit obtenue, de sorte que le scanner à résonance magnétique soit adapté pour la soumission des signaux de résonance magnétique à une modulation de fréquence localement spécifique uniquement pendant la période de lecture de l'étape de collecte des signaux de résonance magnétique,
- le dispositif de commande (120) est configuré pour le réglage de l'au moins un champ de modulation magnétique variable dans le temps et spatialement restreint, et
- le dispositif de reconstruction (130) est configuré pour la reconstruction de l'image d'objet en utilisant la modulation de fréquence localement spécifique des signaux de résonance magnétique pour l'obtention d'informations spatiales d'image provenant des signaux de résonance magnétique spatialement codés.

11. Dispositif d'IRM selon la revendication 10, qui est adapté pour l'exécution du procédé d'imagerie par TRM selon l'une des revendications 2 à 9.

FIG. 1

FIG. 2

A

B

FIG. 3

FIG. 4

FIG. 5

original image

simulated magnitude (from entire reaout)

FIG. 6

simulated phase, 1st virtual image

simulated phase, 2nd virtual image

simulated phase, 3rd virtual image

simulated phase, 4th virtual image

FIG. 7

FIG. 8

FIG. 9

FIG. 10

FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 7411395 B
- US 6255821 B

- US 20110080169 A1

**Non-patent literature cited in the description**

- **P. C. LAUTERBUR.** *Nature,* 1973, vol. 242, 190-191
- **P. MANSFIELD et al.** *Journal of Physics C, Solid State Physics,* 1973, vol. 6, L422-L426
- **S. LJUNGGREN.** *J. Magn. Reson.,* 1983, vol. 54, 338-343
- **D. B. TWIEG.** *Med. Phys.,* 1983, vol. 10, 610-621

- **W. A. EDELSTEIN et al.** *Phys. Med. Biol.,* vol. 25, 751-756
- **K. P. PRUESSMANN et al.** *Magn. Reson. Med.,* 1999, vol. 42, 952-962
- **M. A. GRISWOLD et al.** *Magn. Reson. Med.,* 2002, vol. 47, 1202-1210
- **J. HENNIG et al.** *Magn. Reson. Mater. Phy.,* 2008, vol. 21, 5-14